# EUROPEAN PATENT SPECIFICATION

(11) **EP 0 755 057 B1**
(45) Date of publication and mention of the grant of the patent: **16.10.2002**
(21) Application number: 96111068.1
(22) Date of filing: 10.07.1996
(51) Int. Cl.: G11C 8/00

(54) **Semiconductor memory device**
Halbleiterspeicheranordnung
Dispositif de mémoire à semi-conducteurs

(30) Priority: 15.07.1995 KR 2091495
(43) Date of publication of application: 22.01.1997
(73) Proprietor: SAMSUNG ELECTRONICS CO., LTD., Suwon-city, Kyungki-do 441-373 (KR)
(72) Inventor: Hwang, Hong-Sun, Suwon-city, Kyungki-do (KR); Yoo, Seung-Moon, Paldal-gu, Suwon-city, Kyungki-do (KR)
(74) Representative: Eisenführ, Speiser & Partner

(56) References cited:
- EP-A- 0 651 393
- US-A- 5 282 175
- TADAHIKO SUGIBAYASHI ET AL: "A 30-NS 256-MB DRAM WITH A MULTIDIVIDED ARRAY STRUCTURE" IEEE JOURNAL OF SOLID-STATE CIRCUITS, vol. 28, no. 11, 1 November 1993, pages 1092-1096, XP000423251

## Description

The present invention relates to semiconductor memory devices, and more particularly including sub word line drivers for a high speed boosting of a word line voltage during a word line enable operation.

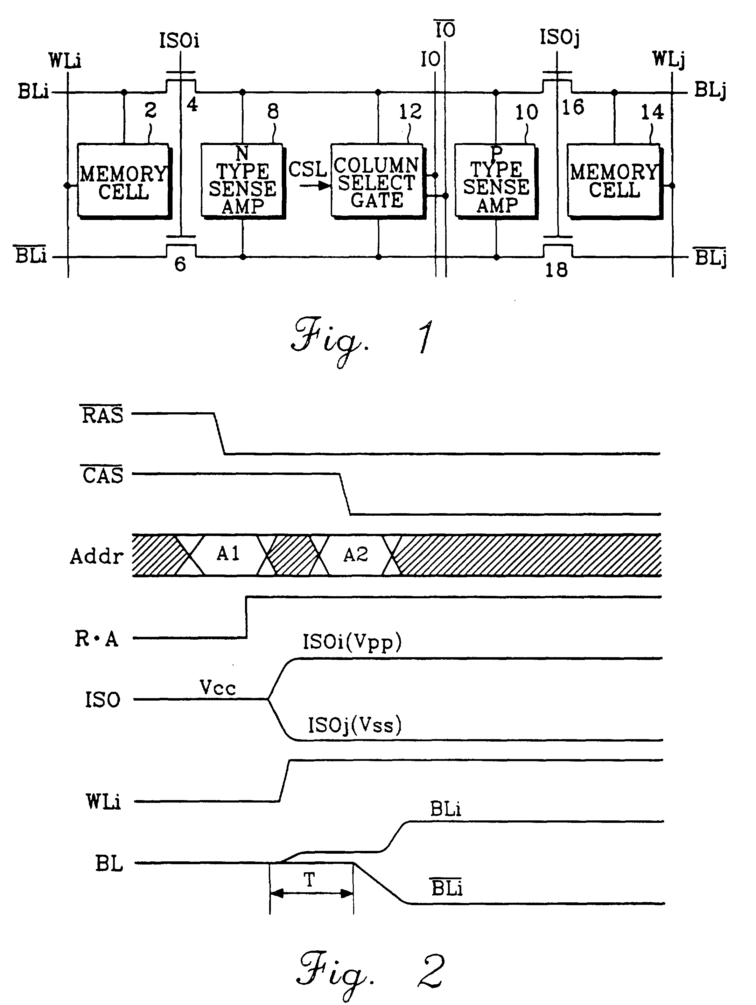

A memory cell composed of a cell capacitor for storing data and a cell access transistor for controlling the input/output of the charge, and its peripheral circuits for reading out or writing data from/into the memory cell constitute a basic structure of a dynamic random access memory (hereinafter referred to as a "DRAM"). Fig. 1 is a block diagram showing a core part of a semiconductor memory device including principal circuits such as sense amplifiers and column select gates. Construction and operation of such a core part is well known in the art. Fig. 2 is a timing diagram for the read operation of Fig. 1. With reference to Figs. 1 and 2, the read operation of the DRAM will be schematically discussed.

When the control signals for a read operation, e.g. a row address strobe signal $\overline{\text{RAS}}$ or a column address strobe signal $\overline{\text{CAS}}$ are toggled to a logic "low" level, various internal control signals which are synchronized with the these control signals are generated within an internal of a chip, and the internal control signals sequentially operate in accordance with a predetermined timing, thus performing a desirable read operation. In a typical memory device, an address multiplexing method is used for reducing the chip size, where an identical address line is controlled by a row address strobe signal or a column address strobe signal, thereby perceiving the input address as a row address or a column address. In the case that the row address is designated, a boosted word line voltage is applied to the word line corresponding to the row address, whereas in the case that the column address is designated, the column selection line connected to a pair of bit lines corresponding to the column address is selected. In DRAMs, selecting the word line refers to the charge sharing between the cell data and the bit line. If a charge sharing operation is performed by selecting any word line, there occurs a predetermined level of voltage difference between the bit lines. A sense amplifier senses and develops the voltage difference between the bit lines, and typically used is the sense amplifier with a P-N Latch structure. Recently, in order to reduce the chip size, the sense amplifier is shared by adjacent memory blocks, and Fig. 1 shows the structure of a shared P-N sense amplifier. In such a shared P-N sense amplifier, the memory cells 2 and 14 are exclusively selected by isolation gate control signals ISOi and ISOj. That is, in the case that the memory cell 2 is selected, the first control signal ISOi goes to a logic "high" level, i.e. the boosting voltage Vpp level, thus turning on isolation gates 4, 6, whereas the second control signal ISOj goes to a logic "low" level, i.e. the ground voltage Vss level, thus turning off isolation gates 16, 18. With the conduction of the isolation gates 4 and 6, a pair of bit lines BLi, $\overline{\text{BLi}}$ the voltage difference of which is several tens mV to several hundreds mV after the charge sharing operation are negative-amplified and positive-amplified by the N-type and P-type sense amplifiers 8 and 10, and then are developed to the power supply voltage Vcc level and the ground voltage Vss level, respectively. Afterthe sufficient development of the bit line pair BLi, $\overline{\text{BLi}}$, a column decoder (not shown) decodes a column address, thereby activating a corresponding column select line CSL to select corresponding column select gate. Thereby, the voltages of the bit line pair BLi, $\overline{\text{BLi}}$ are supplied to the I/O lines IO, $\overline{\text{IO}}$ and then transferred to an exterior of the chip through a series of output-associated circuits. In this way, the read operation for reading-out one bit of data is completed.

If a word line is selected, a charge sharing operation is performed between the designated memory cell and the parasitic capacitor of the bit lines. However, if the sense amplifier operates before the charge sharing operation is sufficiently performed, the voltages of the bit line pair BLi, $\overline{\text{BLi}}$ cannot be sufficiently developed to a predetermined CMOS potential difference, thereby increasing the possibility of malfunctions of the memory device. Therefore, ensuring the sufficient charge sharing time between the bit line and the memory cell determines the operating characteristic of the DRAM. To solve this problem, typically proposed is a method of reducing the time required for the word line to be selected and to reach a predetermined voltage level Vcc + Vt(where Vt is a threshold voltage of an access transistor). For this, a conventional semiconductor memory device uses a strapping method and this method will be briefly described hereinbelow.

Polysilicon material (gate poly) made of high resistive material is used as a control electrode (gate terminal) of the cell access transistor of the memory cell. A metal line made of low resistive material is formed over the gate poly, with being in contact with the gate poly at a predetermined interval. That is, the time required in selecting the word line is determined by the low resistive metal, allowing an increase of the transmission speed, and this enables a high speed charge sharing operation. Such a strapping method is useful to the DRAM device with a great design rule but is not suitable to the DRAM device with a small design rule (integrated circuits with reduced width) because of the difficulty in manufacturing. Since the metal process which follows the gate poly process is performed in the state where the materials are not planar, it is difficult to secure the process margin. Therefore, in memory devices over 256Mb DRAM with very small design rule, it is almost impossible to dispose the metal line over every word line for a strapping. Further, it is very difficult to open a contact hole between the metal and the word line and then fill it with the metal due to a deep topology. In order to solve this problem, a method is proposed for making the word lines have a hierarchical structure. This hierarchical structure is embodied by sub word lines, and a sub word line driver serves to selectively designate the sub word lines.

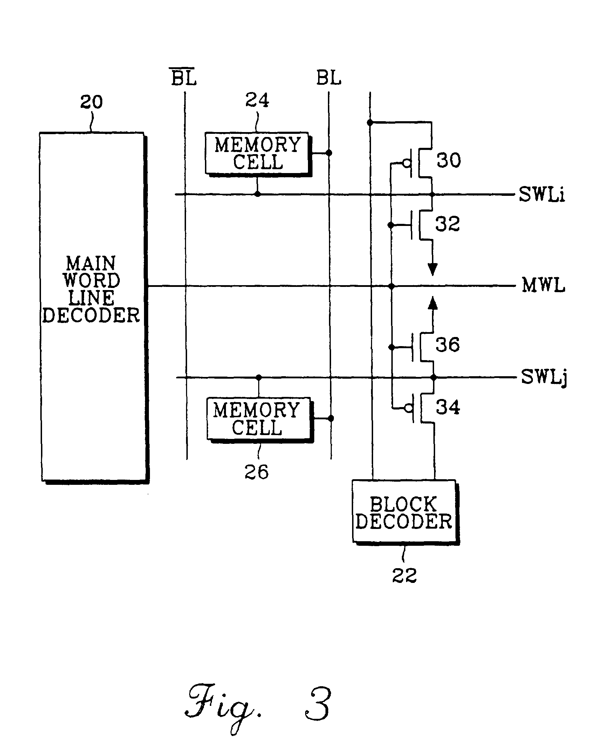

Fig. 3 is a circuit diagram showing a CMOS sub word line driver according to a prior art. In Fig. 3, a main word line MWL is placed every predetermined number of sub word lines, and one sub word line is selected by the combination of the output of a block decoder 22 and the main word line MWL. That is, after the main word line MWL is activated to a logic "low" level by a main word line decoder 20, the boosting voltage is supplied from the block decoder 22 to the sub word line SWLi or SWLj via PMOS transistor 30 or 34 of the CMOS sub word line driver. Since the main word line MWL is not necessary to be placed every sub word line, it is possible to manufacture the main word line with sufficient space.

However, the configuration of Fig. 3 has a disadvantage in its lay-out. That is, since the sub word line driver of Fig. 3 requires the PMOS transistors, an N type well should be formed on a P type substrate for the PMOS transistors, thus lowering the density of the memory device. In order to solve this problem, a sub word line driver having only NMOS transistors is disclosed in an article "A 30ns 256Mb DRAM with Multi-Divided Array Structure" IEEE 1993, pp 50-51, by the NEC Co., Ltd. in Japan.

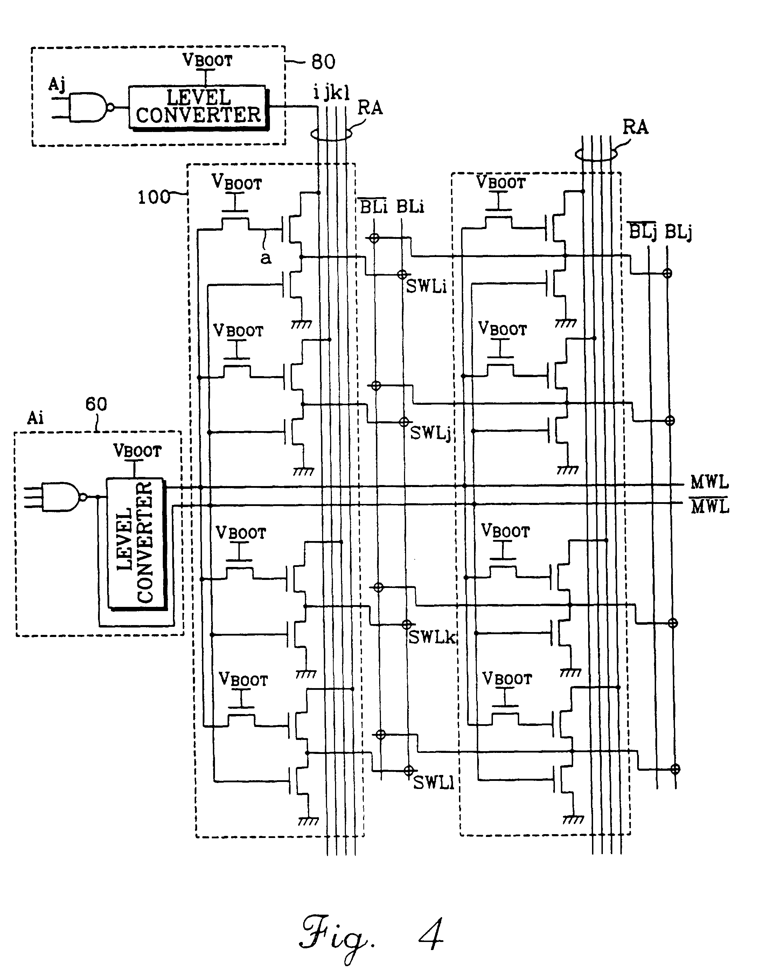

Fig. 4 is a circuit diagram showing the sub word line driver disclosed in the above-referenced article. After the row address strobe signal goes to the logic "low" level, a main row decoder 60 decodes a part of the row addresses and a sub row decoder 80 decodes the other part of the row addresses. A node a of a sub word line driver 100 is precharged to V_{BOOT} - V_{TN} level by the main row decoder 60. Thereafter, if one of the lines RA is selected by the sub row decoder 80, assuming that the line i is selected, a sub word line SWLi is selected by the combination of i and a.

However, such a sub word line driver as Fig. 4 has several problems as follows. Firstly, it is difficult to charge up the main word line to a desired boosting voltage V_{BOOT} level in the power-up and stand-by states. The boosting voltage V_{BOOT} generated within an interior of a chip is clamped to a predetermined voltage level upon the power-up of the memory device. Thereafter, in a stand-by state, the main word line MWL should maintain a ground voltage Vss level and $\overline{\text{MWL}}$ should be precharged to V_{BOOT} level. This is due to the structural characteristic of the circuit that the main word lines are paired and have opposite phases each other. The loading of the signal lines that the boosting circuit in a 16Mb DRAM should drive is about 6nF. In the case of increasing the memory capacity to 256Mb DRAM, the loading becomes several tens nF, and thus it is difficult to charge up the main word line to a desirable V_{BOOT} level during the power-up and stand-by states. Secondly, the stand-by current increases if there occurs a micro bridge due to particle of dust of impurities between conductive layers. In Fig. 4, a pair of main word lines MWL, $\overline{\text{MWL}}$ which have opposite potential each other are in parallel with each other in an identical direction. In the stand-by state, the main word line MWL stays at the ground voltage Vss level and $\overline{\text{MWL}}$ maintains the boosting voltage V_{BOOT} level. If there occurs a micro bridge between these two lines, a current path is formed from $\overline{\text{MWL}}$ to MWL, i.e. from V_{BOOT} to the ground voltage, thus continuously dropping the V_{BOOT} level. Since the V_{BOOT} is generated internally of the chip, if V_{BOOT} is voltage-dropped, the circuits such as an oscillator and a detector must continuously operate to restore V_{BOOT} to its original voltage level. This causes an increase of stand-by current. Such a current consumption remains even when the word lines between which the micro bridge occurs are replaced by the redundant word lines. Further, in the case of the memory device with small design rule, there occurs more often the micro bridge. The increase of the stand-by current due to the micro bridge effects an increase of the fail of the chip.

US-A-5 282 175 discloses a sub-wordline driver of CMOS type.

It is therefore an object of the present invention to provide a semiconductor memory device which can reduce the loading of a boosting voltage generator.

It is another object of the present invention to provide a semiconductor memory device which can reduce a speed loss during an access operation by using a sub word line driver.

It is still another object of the present invention to provide a semiconductor memory device which can prevent failures due to the increase of stand-by current when there occurs a micro bridge between adjacent lines.

To achieve the above objects, a semiconductor memory device having a main row decoder for decoding a part of row addresses and a sub row decoder for decoding the other part of said row addresses includes at least one sub word line driver which inputs a main word line outputted from the main row decoder and decoding signals outputted from the sub row decoder and then outputs a sub word line for selecting a memory cell, as defined by claim 1.

Preferable embodiments are defined in dependent claims.

The features and advantages of the present invention will be readily understood with reference to the following detailed description taken in conjunction with the accompanying drawings, in which:
- Fig. 1: is a block diagram showing a construction of a core part of a semiconductor memory device;
- Fig. 2: is a timing diagram showing a read operation of Fig. 1;
- Fig. 3: is a circuit diagram showing a CMOS sub word line driver according to a prior art;
- Fig. 4: is a circuit diagram showing NMOS sub word line drivers according to a prior art; and
- Fig. 5: is a circuit diagram showing NMOS sub word line drivers according to the present invention.

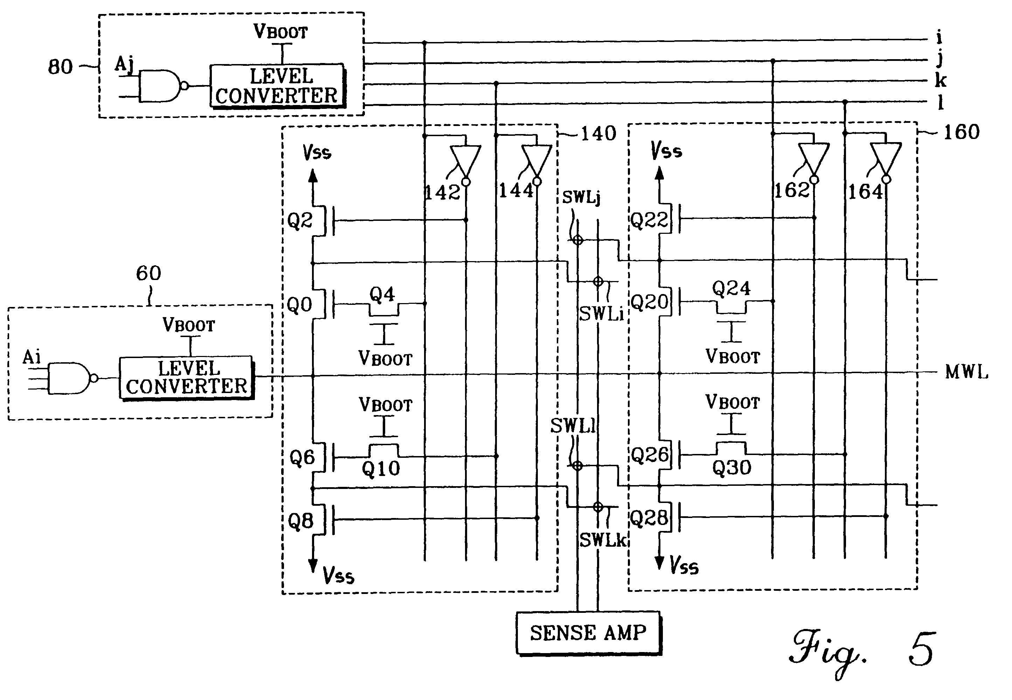

A preferred embodiment of the present invention will be more fully discussed with reference to Fig. 5.

Fig. 5 is a circuit diagram showing two sub word line drivers 140, 160 of a semiconductor memory device according to a preferred embodiment of the present invention. The sub word line drivers 140 and 160 serve a first, a second, a third and a fourth sub word line SWLi, SWLj, SWLk, SWLl. Referring to Fig. 5, a main row decoder 60 comprised of a unit for decoding a part of the row addresses, e.g. the row address Ai and a level converter is connected to the main word line MWL. A sub row decoder 80 comprised of a unit for decoding the other part of the row addresses, e.g. the row address Aj and a level converter is connected to decoded address lines i, j, k and l.

The sub word line driver 140 includes a first pull-up transistor Q0 which has one end connected to the main word line MWL and the other end connected to the first sub word line SWLi, a first pull-down circuit (third transistor) Q2 which has one end connected to the first sub word line SWLi and the other end connected to a ground voltage Vss, a first precharge circuit (fifth transistor) Q4 which has one end connected to a first line i of the decoded address lines i, j, k and l, the other end connected to a control electrode of the first pull-up transistor Q0 and a control electrode connected to a boosting voltage V_{BOOT}, a second pull-up transistor Q6 which has one end connected to the main word line MWL and the other end connected to the third sub word line SWLk, a second pull-down circuit (fourth transistor) Q8 which has one end connected to the third sub word line SWLk and the other end connected to the ground voltage Vss, a second precharge circuit (sixth transistor) Q10 which has one end connected to a third line k of the decoded address lines, the other end connected to the control electrode of the second pull-up transistor Q6 and a control electrode connected to the boosting voltage V_{BOOT}, a first inverter 142 which has an input terminal connected to the first line i and an output terminal connected to a control electrode of the first pull-down circuit (third transistor) Q2, and a second inverter 144 which has an input terminal connected to the third line k and an output terminal connected to a control electrode of the second pull-down circuit (fourth transistor) Q8.

The sub word line driver 160 has an identical construction to the sub word line driver 140. The sub word line driver 160 inputs the second and fourth decoded address lines j and I which are not connected to the sub word line driver 140 and provides outputs to the second and fourth sub word lines SWLj and SWLI.

Operation of the sub word line driver according to a preferred embodiment of the present invention will be discussed with reference to Fig. 5.

When the row address strobe signal $\overline{\text{RAS}}$ is at a logic "high" state, see Fig. 2, the chip is in the stand-by state and the main word line MWL stays at ground voltage level Vss. With the transition of the row address strobe signal $\overline{\text{RAS}}$ to the logic "low" level, the chip changes to an activating state and addresses applied from an exterior are latched as row addresses by a row address buffer (not shown). The sub row decoder 80 decodes the least significant two bits of the row address, e.g. the row address Aj and then transfers the boosting voltage V_{BOOT} to one line of the decoded address lines i, j, k and I via the level converter. It is assumed in the present invention that the boosting voltage V_{BOOT} is applied to the first line i, for the convenience of description. And the main row decoder 60 decodes the other addresses Ai of the row addresses and then transfers the boosting voltage V_{BOOT} to corresponding sub word line SWLi via the level converter.

The process of transferring the boosting voltage V_{BOOT} to the sub word line SWLi is as follows. Only the first decoded line i stays at a logic "high" level and the remaining decoded lines j, k and I are at logic "low" levels. Thus, the output of the first inverter 142 is at a logic "low" level and the output of the second inverter 144 and the outputs of the first and second inverters 162, 164 in the adjacent sub word line driver 160 are all at logic "high" levels. As a result, the pull-down circuits Q8, Q22 and Q28 become conductive, whereas the pull-down circuit Q2 becomes nonconducting. Thereby, the voltages of the sub word lines SWLj, SWLk and SWLI are discharged to the ground voltage level Vss.

The other end of the first precharge circuit Q4 in the sub word line driver 140 is precharged to V_{BOOT} - Vth level(where Vth is a threshold voltage of a precharge transistor). Thereafter, the boosting voltage V_{BOOT} is supplied from the main row decoder 60 to the sub word line SWLi through the first pull-up transistor Q0. After the sub word line activation operation, there occurs a charge sharing operation between the memory cell capacitor and the bit line. Then, the sense amplifier senses this and develops the voltage difference between the bit lines to a CMOS level potential difference. Thereafter, the data stored at the memory cell capacitor is transferred to the I/O line through the column select gate and then is output to an exterior of the chip through a series of data path control circuits.

As described above, in the semiconductor memory device according to the present invention, since the main word line MWL stays at the ground voltage level Vcc in the stand-by state, the number of the signals which should be charged to the boosting voltage level V_{BOOT} is reduced, thus solving the problem of lowering the boosting voltage V_{BOOT} level due to the large amount of supply during the power-up and stand-by states. In addition, since there is one main word line MWL per four sub word lines SWLi, SWLj, SWLk, SWLI and the precharge voltage level of the main word line is the ground voltage level Vcc, the occurrence of the micro bridge between the adjacent word lines can be suppressed. Even if there occurs a micro bridge between the adjacent word lines, the discharging path can be isolated by replacing the word lines with the redundant word lines. This enhances the yield and the overall performance of the DRAM device.

Accordingly, the semiconductor memory device using the sub word line drivers 140, 160 according to the present invention can solve the word line strapping problem in a small design rule and prevent failures due to the micro bridge, thereby realizing a semiconductor memory device with improved performance.

## Claims

1. A semiconductor memory device comprising:
a main row decoder (60) for decoding a part (Ai) of row addresses;
a sub row decoder (80) for decoding the other part (Aj) of said row addresses;
at least two sub word line drivers (140, 160) receiving an input of a main word line signal (MWL) outputted from said main row decoder (60) and decoding signals (i, j, k, l) outputted from said sub row decoder (80) and then providing an output on a sub word line (SWLᵢ, SWLⱼ, SWLₖ, SWLₗ) for selecting a memory cell (2, 14);
said sub row decoder (80) decoding and converting two bits of row addresses (Aj) to a boosting voltage level (V_{BOOT}) and then outputting said decoding signals (i, j, k, l);
each of said sub word line drivers (140, 160) comprising:
first and second transistors (Q0, Q6/Q20, Q26) commonly connected to said main word line (MWL);
a third transistor (Q2/Q22) which has its channel connected between said first transistor (Q0/Q20) and a ground voltage (Vss) and its control electrode connected to an inverted signal of a first or second decoding signal (i/j) of said decoding signals,
a common connection node of said first and third transistors (Q0, Q2/Q20, Q22) being connected to a first or second sub word line (SWLi/SWLj);
a fourth transistor (Q8/Q28) which has its channel connected between said second transistor (Q6/Q26) and said ground voltage (Vss) and its control electrode connected to an inverted signal of a third or fourth decoding signal (k/l) of said decoding signals, a common connection node of said second and fourth transistors (Q6, Q8/Q26, Q28) being connected to a third or fourth sub word line (SWLk/SWLl);
a fifth transistor (Q4/Q24) which has its channel connected between a control electrode of said first transistor (Q0/Q20) and said first or second decoding signal (i,j) and its control electrode connected to said boosting voltage (V_{BOOT}); and
a sixth transistor (Q10/Q30) which has its channel connected between a control electrode of said second transistor (Q6/Q26) and said third or fourth decoding signal (k/l) and its control electrode connected to said boosting voltage (V_{BOOT}).

2. The semiconductor memory device according to claim 1, wherein said first, second, third, fourth, fifth and sixth transistors (Q0, Q6, Q2, Q8, Q4, Q10/Q20, Q26, Q22, Q28, Q24, Q30) are NMOS transistors.

3. The semiconductor memory device according to claim 1 or 2 wherein said boosting voltage (V_{BOOT}) is higher than an internal operating power supply voltage.

4. The semiconductor memory device according to claim 5, wherein said main word line (MWL) stays at said boosting voltage level (V_{BOOT}) in an activating state.

## Patentansprüche

1. Halbleiter-Speicherbauelement, umfassend:
einen Hauptreihen-Dekoder (60) zum Dekodieren eines Teils (Ai) von Reihenadressen;
einen Subreihen-Dekoder (80) zum Dekodieren des anderen Teils (Aj) der Reihenadressen;
mindestens zwei Subzeilen-Treiber (140, 160), die eine Eingabe von einem vom Hauptreihen-Dekoder (60) ausgegebenen Hauptzeilen-Signal (MWL) empfangen, und vom Subreihen-Dekoder ausgegebene Signale (i, j, k, l) dekodieren and anschließend eine Ausgabe auf einer Subzeile (SWLᵢ, SWLⱼ, SWLₖ, SWLₗ) zum Auswählen einer Speicherzelle (2, 14) bereitstellen;
wobei der Subreihen-Dekoder (80) zwei Bit von Reihenadressen (Aj) in ein Boost-Spannungsniveau (V_{BOOT}) wandelt und anschließend die Dekodiersignale (i, j, k, l)ausgibt;
wobei jeder Subzeilen-Treiber (140, 160) umfasst:
erste und zweite Transistoren (Q0, Q20, Q26) die gemeinsam mit der Hauptzeile (MWL) verbunden sind;
einen dritten Transistor (Q2/Q22), dessen Kanal verbunden ist zwischen dem ersten Transistor (Q0/Q20) und einer Massespannung (Vss), und dessen Steuerelektrode verbunden ist mit einem invertierten Signal eines ersten oder zweiten Dokodiersignals (i/j) der Dekodiersignale, wobei ein gemeinsamer Verbindungsknoten des ersten und des dritten Transistors (Q0, Q2/Q20, Q22) mit einer ersten oder zweiten Subzeile verbunden ist (SWLᵢ/SWLⱼ);
einen vierten Transistor (Q8/Q28), dessen Kanal verbunden ist einerseits mit dem zweiten Transistor (Q6/Q26) und andererseits mit der Massespannung, und dessen Steuerelektrode verbunden ist mit einem invertierten Signal eines dritten oder vierten Dekodiersignals (k/l) der Dekodiersignale, wobei ein gemeinsamer Verbindungsknoten des zweiten und des vierten Transistors (Q6, Q8/Q26, Q28) mit einer dritten oder vierten Subzeile verbunden ist (SWLₖ/SWLₗ);
einen fünften Transistor (Q4/Q24), dessen Kanal verbunden ist einerseits mit einer Steuerelektrode des ersten Transistors (Q0/Q20) und andererseits mit dem ersten oder zweiten Dekodiersignal (i, j), und dessen Steuerelektrode verbunden ist mit der Boost-Spannung (V_{BOOT}); und
einen sechsten Transistor (Q10/Q30), dessen Kanal verbunden ist einerseits mit einer Steuerelektrode des zweiten Transistors (Q6/Q26) und andererseits mit dem dritten oder vierten Dekodiersignal (k/l), und dessen Steuerelektrode mit der Boost-Spannung (V_{BOOT}) verbunden ist.

2. Halbieiter-Speicherbauelement nach Anspruch 1, bei dem der erste, zweite, dritte, vierte, fünfte und sechste Transistor (Q0, Q6, Q2, Q8, Q4; Q10/Q20, Q26, Q22, Q28, Q24, Q30) ein NMOS-Transistor ist.

3. Halbleiter-Speicherbauelement nach Anspruch 1 oder 2, bei dem die Boost-Spannung (V_{BOOT}) höher ist als eine interne Arbeitsspannung der Leistungsversorgung.

4. Halbleiter-Speicherbauelement nach Anspruch 5 (sic!), bei dem die Hauptzeile (MWL) in einem aktivierenden Zustand auf dem Boost-Spannungsniveau (V_{BOOT}) bleibt.

## Revendications

1. Dispositif de mémoire à semiconducteurs comportant :
un décodeur (60) de rangée principale destiné à décoder une partie (Ai) d'adresses de rangée ;
un décodeur (80) de rangée secondaire destiné à décoder l'autre partie (Aj) desdites adresses de rangée ;
au moins deux circuits d'attaque (140, 160) de lignes de mots secondaires recevant une entrée d'un signal (MWL) de ligne de mot principal délivré en sortie dudit décodeur (60) de rangée principale et décodant des signaux (i, j, k, l) délivrés en sortie- dudit décodeur (80) de rangée secondaire, puis produisant une sortie sur une ligne de mot secondaire (SWLᵢ, SWLⱼ, SWLₖ, SWLₗ) pour sélectionner une cellule de mémoire (2, 14) ; ledit décodeur (80) de rangée secondaire décodant et convertissant deux bits d'adresses (Aj) de rangée en un niveau de tension additionnelle (V_{BOOT}) puis délivrant en sortie lesdits signaux de décodage (i, j, k, l) ;
chacun desdits circuits d'attaque (140, 160) de lignes de mots secondaires comportant :
des premier et deuxième transistors (Q0, Q6/Q20, Q26) connectés en commun à la dite ligne de mot principal (MWL) ;
un troisième transistor (Q2/Q22) dont le canal est connecté entre ledit premier transistor (Q0/Q20) et une tension de masse (Vss) et dont l'électrode de commande est connectée à un signal inversé d'un premier ou deuxième signal de décodage (i/j) desdits signaux de décodage, un noeud de connexion commune desdits premier et troisième transistors (Q0, Q2/Q20, Q22) étant connecté à une première ou seconde ligne de mot secondaire (SWLi/SWLj) ;
un quatrième transistor (Q8/Q28) dont le canal est connecté entre ledit deuxième transistor (Q6/Q26) et ladite tension de masse (Vss) et dont l'électrode de commande est connectée à un signal inversé d'un troisième ou quatrième signal de décodage (k/l) desdits signaux de décodage, un noeud de connexion commune desdits deuxième et quatrième transistors (Q6, Q8/Q26, Q28) étant connecté à une troisième ou quatrième ligne de mot secondaire (SWLk/SWLl) ;
un cinquième transistor (Q4/Q24) dont le canal est connecté entre une électrode de commande dudit premier transistor (Q0/Q20) et ledit premier ou deuxième signal de décodage (i, j) et dont l'électrode de commande est connectée à ladite tension additionnelle (V_{BOOT}) ; et
un sixième transistor (Q10/Q30) dont le canal est connecté entre une électrode de commande dudit deuxième transistor (Q6/Q26) et ledit troisième ou quatrième signal de décodage (k/l) et dont l'électrode de commande est connectée à ladite tension additionnelle (V_{BOOT}).

2. Dispositif de mémoire à semiconducteurs selon la revendication 1, dans lequel lesdits premier, deuxième, troisième, quatrième, cinquième et sixième transistors (Q0, Q6, Q2, Q8, Q4, Q10/Q20, Q26, Q22, Q28, Q24, Q30) sont des transistors du type NMOS.

3. Dispositif de mémoire à semiconducteurs selon la revendication 1 ou 2, dans lequel ladite tension additionnelle (V_{BOOT}) est supérieure à une tension d'alimentation en énergie de fonctionnement interne.

4. Dispositif de mémoire à semiconducteurs selon la revendication 5, dans lequel ladite ligne de mot principal (MWL) reste audit niveau de tension additionnelle (V_{BBOT}) dans un état d'activation.
